**Europäisches Patentamt**

**European Patent Office**

**Office européen des brevets**

(19)

(11) Veröffentlichungsnummer: **0 136 364**

**B1**

(12)     **EUROPÄISCHE PATENTSCHRIFT**

(45) Veröffentlichungstag der Patentschrift:
20.07.88

(21) Anmeldenummer: **83109479.2**

(22) Anmeldetag: **23.09.83**

(51) Int. Cl.⁴: **H 05 K 3/10, C 23 C 14/36**

E R R A T U M

(SEITE, SPALTE, ZEILE)
(PAGE, COLUMN, LINE)
(PAGE, COLONNE, LIGNE)

| DIE TEXTSTELLE:<br>TEXT PUBLISHED:<br>LE PASSAGE SUIVANT: | | | | LAUTET BERICHTIGT:<br>SHOULD READ:<br>DEVRAIT ETRE LU: |
|---|---|---|---|---|
| und den leitenden Bereiche Tesla-Ströme erzeugt werden. | 5 | 7 | 07/08 | und den leitenden Bereichen (2) Tesla-Ströme erzeugt werden. |
| und an der Reaktionskammer einen Gaseinlaß zum Zugeben. | 5 | 8 | 27/28 | und an der Reaktionskammer einen Gaseinlaß zum Zugeben definierter Gasmengen aufweist. |

| Tag der Entscheidung<br>über die Berichtigung )<br>Date of decision on )<br>rectification: )<br>Date de décision portant )<br>sur modification: ) | 18.08.88 | Ausgabe- und Ver-<br>öffentlichungstag: )<br>Issue and publication )<br>date: )<br>Date d'edition et de )<br>publication: ) | 19.10.88 | Patbl.Nr.)<br>EPB no:)<br>Bull. no:) | 88/42 |

## Europäisches Patentamt
## European Patent Office
## Office européen des brevets

(11) Veröffentlichungsnummer: **0 136 364**
**B1**

(12) **EUROPÄISCHE PATENTSCHRIFT**

(45) Veröffentlichungstag der Patentschrift:
20.07.88

(51) Int. Cl.⁴: **H 05 K 3/10, C 23 C 14/36**

(21) Anmeldenummer: **83109479.2**

(22) Anmeldetag: **23.09.83**

(54) Verfahren und Anordnung zum selektiven, selbstjustierten Aufbringen von Metallschichten und Verwendung des Verfahrens.

(43) Veröffentlichungstag der Anmeldung:
**10.04.85 Patentblatt 85/15**

(45) Bekanntmachung des Hinweises auf die Patenterteilung:
**20.07.88 Patentblatt 88/29**

(84) Benannte Vertragsstaaten:
**DE FR GB IT**

(56) Entgegenhaltungen:
EP-A-0 002 383
DE-A-1 947 480
FR-A-1 413 304
FR-A-2 075 468
GB-A-1 128 002

(73) Patentinhaber: **IBM DEUTSCHLAND GMBH,
Pascalstrasse 100, D-7000 Stuttgart 80 (DE)**
(84) Benannte Vertragsstaaten: **DE**

(73) Patentinhaber: **International Business Machines
Corporation, Old Orchard Road, Armonk, N.Y.
10504 (US)**
(84) Benannte Vertragsstaaten: **FR GB IT**

(72) Erfinder: **Bayer, Thomas, Uhlbergstrasse 15, D-7030
Böblingen (DE)**
Erfinder: **Kraus, Georg, Im Heinetal 70, D-7277
Wildberg 4 (DE)**
Erfinder: **Künzel, Ulrich, Dr. Dipl.- Chem., August
Lämmlestrasse 8, D-7408 Kusterdingen (DE)**
Erfinder: **Renz, Gisela, Döffinger Strasse 129,
D-7031 Grafenau 2 (DE)**
Erfinder: **Schäfer, Rolf, Dr. Dipl.- Mineraloge,
Ritterstrasse 25, D-7031 Gärtringen- Rohrau (DE)**

(74) Vertreter: **Oechssler, Dietrich, Dr. rer. nat., IBM
Deutschland GmbH Patentwesen und
Urheberrecht Schönaicher Strasse 220, D-7030
Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zum selektiven und selbstjustierenden Aufbringen von mindestens einer Metallschicht auf leitende Bereiche an der Oberfläche von isolierenden oder halbleitenden Substraten, eine Anordnung zur Durchführung und eine Verwendung des Verfahrens.

Verfahren der genannten Art lassen sich bisher nur naßchemisch durchführen, indem stromlos oder elektrolytisch ein Metall aus der Lösung eines seiner Salze auf leitfähig gemachten bzw. aktivierten Bereichen an der Oberfläche eines isolierenden Substrats abgeschieden wird. Naßchemische verfahren haben den Nachteil, daß die zu beschichtenden Substrate verunreinigt werden, was die Funktion der herzustellenden Teile beeinträchtigen kann, und bei der Entsorgung der für die Beschichtung verwendeten Bäder treten Umweltprobleme auf. Trockene Beschichtungsverfahren, wie z. B. das Kathodenzerstäuben und das Aufdampfen werden hauptsächlich dann angewandt, wenn ganzflächig Metallschichten auf ein Substrat aufgebracht werden sollen. Es ist zwar auch bei diesen trockenen Verfahren möglich, Metall selektiv auf Substrate aufzubringen, und zwar indem eine Metallmaske, welche durchgehende Löcher entsprechend dem aufzubringenden Metallmuster aufweist, auf das Substrat gelegt oder in einem geringen Abstand von ihm angeordnet wird. Es ist jedoch so, daß die Herstellung dieser Metallmasken relativ kompliziert ist, und daß es notwendig ist, die Metallmaske zum Substrat sehr genau auszurichten. Muß das Substrat vor dem Aufbringen des Metalls Verfahrensschritten unterworfen werden, bei denen es einer nichts völlig kontrollierbaren Schrumpfung unterworfen ist, dies trifft z. B. bei Keramik- oder Kunststoffsubstraten zu, dann ist das selektive Aufbringen von Metallschichten in einer auf bereits auf dem Substrat vorhandenen Strukturen angepaßten Ausbildung mittels Metallmasken nur dann möglich, wenn die zulässigen Fertigungstoleranzen sehr groß sind. Mit dem zunehmenden Trend zur Mikrominiaturisierung und der damit verbundenen immer höheren Packungsdichte und kleiner werdenden Breite von Leiterzügen ist eine solche großzügige Bemessung der Fertigungstoleranzen nicht mehr möglich.

Es ist die Aufgabe der Erfindung, ein einfaches Verfahren und eine einfache Anordnung, um leitende Bereiche auf der Oberfläche von nichtleitenden oder halbleitenden Substraten reproduzierbar unter Einhaltung enger Fertigungstoleranzen ohne eine Verunreinigung der Substrate zu metallisieren, und eine Verwendung dieses Verfahrens anzugeben.

Diese Aufgabe wird mit einem Verfahrens der eingangs genannten Art mit den Merkmalen des kennzeichnenden Teils des Patentanspruchs 1, einer Anordnung der eingangs genannten Art mit den Merkmalen des kennzeichnenden Teils des Patentanspruchs 10 und mit einer Verwendung gemäß dem Patentanspruch 14 gelöst.

Der Mechanismus, nach dem das erfindungsgemäße Verfahren abläuft, ist nicht bekannt.

Das erfindungsgemäße Verfahren ist ein Trockenverfahren. Infolgedessen werden die zu beschichtenden Substrate bei seiner Anwendung nicht verunreinigt, und da keine Bäder entsorgt werden müssen, treten auch keine Umweltprobleme auf. Zum selektiven Metallisieren werden bei dem erfindungsgemäßen Verfahren keine Masken benötigt; dadurch spart man sich nicht nur den Aufwand der Maskenherstellung, sondern es ist auch unkritisch, wenn die Substrate und damit auch die leitenden Bereiche an ihrer Oberfläche, welche metallisiert werden sollen, bei Verfahrensschritten, welche der Metallisierung vorausgehen, in nicht völlig kontrollierbarer Weise schrumpfen. Solche Schrumpfungen können z. B. dann auftreten, wenn das Substrat aus einem Keramikmaterial oder aus einem Kunststoff besteht. Das erfindungsgemäße Verfahren ist schonend, beansprucht deshalb die beteiligten Materialien wenig und ist deshalb flexibel bezüglich der Substratmaterialien, bezüglich der Materialien, aus welchen die leitenden Bereiche bestehen und auch der Metalle, welche in Schichtform aufgebracht werden. Die Substrate können aus einem isolierenden Material, wie z. B. einem Kunststoff oder einem Keramikmaterial, oder einem halbleitenden Material, wie z. B. Silicium, die leitenden Bereiche aus jedem beliebigen, hinreichend leitfähigen Material, d.h. bevorzugt aus einem Metall, bestehen und aufbringen lassen sich eine große Anzahl von Metallen, insbesondere alle diejenigen, welche bei der Herstellung von integrierten und gedruckten Schaltungen eingesetzt werden.

Das erfindungsgemäße Verfahren ist in den Fällen besonders vorteilhaft, in welchen eine Metallisierung aus zwei oder mehr Schichten aus unterschiedlichen Metallen besteht, weil es erlaubt, wenn eine entsprechend aufgebaute Metallplatte verwendet wird - solche Schichtfolgen in einem Verfahrensschritt aufzubringen.

Da das erfindungsgemäße Verfahren bei Normaldruck in Luft und unter Verwendung eines handelsüblichen Tesla-Transformators ohne den Einsatz komplizierter Justiervorrichtungen durchgeführt werden kann, ist die Anordnung, die für das Verfahren benötigt wird, in ihrem Aufbau sehr einfach und wenig aufwendig. Die Anordnung kann allerdings auch eine evakuierbare Reaktionskammer, in welcher das Aufbringen des Metalls stattfindet, und an der Reaktionskammer einen Gaseinlaß zum Zugeben definierter Gasmengen aufweisen. Über den Gasdruck und das verwendete Gas läßt sich die Aufwachsgeschwindigkeit beeinflussen. Außerdem kann man, wenn man im Vakuum oder in einer keinen Sauerstoff enthaltenden Atmosphäre arbeitet, den Einbau dieses Gases in das aufwachsende Metall verhindern.

In vorteilhafter Weise läßt sich das erfindungsgemäße Verfahren zur Herstellung von Leiterzügen auf oder in - auch mehrschichtigen - Moduls, Schaltkarten und Halbleiterkörpern und von Reproduktionen metallischer Strukturen und als Repariertechnik verwenden

Vorteilhafte Ausgestaltungen des erfindungsgemäßen Verfahrens und der erfindungsgemäßen Anordnung sind in den Unteransprüchen angegeben.

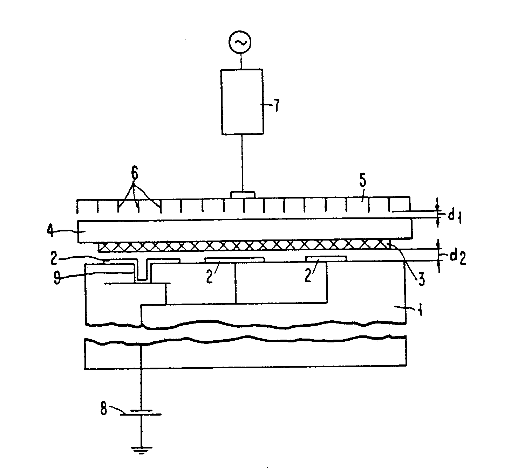

Die Erfindung wird anhand von durch eine Figur erläuterten Ausführungsbeispielen beschrieben. Die Figur zeigt in schematischer Querschnittsdarstellung eine Ausführungsform der erfindungsgemäßen Anordnung.

Im folgenden soll die erfindungsgemäße Anordnung anhand der Figur im einzelnen besprochen werden.

Die Anordnung weist eine Metallplatte 3, aus dem Material, welches transferiert werden soll, auf. Die Metallplatte ist bei der in der Figur gezeigten Ausführungsform auf eine isolierende Platte 4, beispielsweise aus Glas, aufgebracht. Die isolierende Platte 4 ist zwischen 0,1 und 3 mm, bevorzugt ungefähr 1 mm, dick. Das Material, aus welchem die Metallplatte 3 besteht, kann beispielsweise durch Kathodenzerstäubung oder Aufdampfen auf die isolierende Platte 4 aufgebracht worden sein. Die Metallplatte 3 besteht entweder aus einem Metall oder ist aus zwei oder mehr Schichten unterschiedlicher Metalle aufgebaut. Das Vorhandensein der isolierenden Platte 4 ist nicht zwingend. Es sind auch Anordnungen brauchbar, welche statt der Kombination aus der isolierenden Platte 4 und der Metallplatte 3 nur eine Metallplatte 3 ausreichender mechanischer Stabilität aufweisen. In der Anordnung ist die Kombination aus Metallplatte 3 und isolierender Platte 4 so angeordnet, daß die Metallplatte 3 nach unten hängt. In geringem Abstand von der Oberfläche der isolierenden Platte 4, welche von der Metallplatte 3 abgewandt ist, befindet sich ein Metallgitter 5, welches elektrisch mit einem Tesla-Transformator 7 verbunden ist. Das Metallgitter ist so ausgebildet, daß es eine große Anzahl, regelmäßig über das Gitter verteilter und auf die dielektrische Platte 4 gerichteter Spitzen 6 aufweist. Statt des Metallgitters 5 kann auch ein Drahtbüschel vorhanden sein, wobei die Drahtspitzen auf die Oberfläche der isolierenden Platte 4 gerichtet sind und das Drahtbüschel so aufgeweitet ist, daß das die Projektion der Drahtspitzen auf die Oberfläche der isolierenden Platte 4 ein Punktmuster mit einer gleichmäßigen Verteilung der Punkte über die Oberfläche darstellen würde. Der Abstand $d_1$ zwischen den Spitzen und der Oberfläche der isolierenden Platte 4 ist $\leqslant$ 1 mm. Bei den Ausführungsformen, welche ohne eine isolierende Platte 4 auskommen, kann der Tesla-Transformator auch elektrisch direkt mit der Metallplatte 3 verbunden sein. Als Tesla-Transformator 7 ist ein handelsüblicher Hochfrequenz-Vakuumprüfer brauchbar, wie er beispielsweise von der Firma Leybold-Heraeus, beispielsweise zur Lecksuche in Vakuumglasapparaturen unter der Typenbezeichnung VP23 angeboten wird. In einem geringen Abstand $d_2$ zu der Metallplatte 3 ist das Substrat 1 vorhanden, das an seiner der Metallplatte 3 zugewandten Oberfläche leitende Bereiche 2 aufweist. Der Abstand $d_2$ liegt bevorzugt zwischen 10 und 100 µm. Die leitenden Bereiche sind elektrisch mit einer Vorspannungsquelle 8 verbunden, mit welcher die leitenden Bereiche auf ein festgelegtes positives Potential gelegt werden können. Alternativ können die leitenden Bereiche 2 auch geerdet sein oder auf einem schwebenden Potential liegen. Die Anordnung kann auch eine evakuierbare Reaktionskammer aufweisen, in welcher sich das Metallgitter 5, die isolierende Platte 4, die Metallplatte 3 und die Substrate 1 befinden, an welche eine Vakuumpumpe angeschlossen ist, und welche einen Gaseinlaß hat.

Im folgenden wird das erfindungsgemäße Verfahren erläutert:

Bei der Erläuterung wird die in der Fig. gezeigte Anordnung sowohl mit als auch ohne eine evakuierbare Reaktionskammer zugrundegelegt. Es sei jedoch klargestellt, daß Anordnungen, welche sich von der in der Fig. gezeigten Anordnung auch durch die anderen oben angesprochenen Alternativen unterscheiden in derselben Weise zur Durchführung des Verfahrens eingesetzt werden können.

Die Substrate, auf deren Oberfläche sich die leitenden Bereiche befinden, können aus isolierenden oder halbleitenden Materialien bestehen. Geeignet sind beispielsweise Kunststoffe, Keramikmaterial, Glaskeramikmaterial und Silicium. Bei der Metallisierung sollen insbesondere Leiterzüge erzeugt, Lötpunkte verstärkt bzw. mit lötbarem Material überzogen und Löcher 9 in isolierenden Schichten zwischen zwei Metallisierungsebenen mit Metall gefüllt werden. Entsprechend ist die Ausbildung der leitenden Bereiche 2, d.h. sie bedecken auf der der Metallplatte zugewandten Oberfläche die Bereiche, auf welchen die Leiterzüge und bzw. die Lötpunkte erzeugt werden sollen und in den Löchern 9 die Wände. Die leitenden Bereiche 2 sind dünne Filme aus irgendeinem leitenden Material, beispielsweise aus Molybdän oder Aluminium. Die auf der isolierenden Platte 4 aufgebrachte Metallplatte 3 ist aufgebaut entsprechend der Metallisierung, welche aufgebracht werden soll. Typische Metalle, welche auf die leitenden Bereiche 2 aufgebracht werden, sind Kupfer, Gold, Chrom, Silber und Nickel. Soll nur ein Metall auf dem Substrat 1 aufgebracht werden, so besteht auch die Metallplatte 3 nur aus einem Metall dessen Schichtdicke mindestens so groß ist, wie die Schichtdicke, welche die aufgebrachte Metallisierung aufweisen soll. Sollen zwei oder mehr Metallschichten auf dem Substrat 1 aufgebracht werden, so werden diese zwei oder mehr Schichten und zwar in der umgekehrten Reihenfolge wie sie nachher auf dem Substrat 1 aufgebracht werden sollen - auf der isolierenden Platte 4 aufgebaut. Dabei sind die Dicken der Schichten in der Metallplatte 3 so dick, wie die Dicken der Metallschichten auf dem Substrat 1 nach Abschluß der Metallisierung sein sollen. Die Adhäsion des Metalls auf der isolierenden Platte 4 beeinflußt die Geschwindigkeit, mit welcher die Metallisierung vor sich geht.

Üblicherweise wird das erfindungsgemäße Verfahren bei Normaldruck und in Luft durchgeführt. Es ist jedoch auch möglich, beispielsweise um die Geschwindigkeit mit welcher die Metallisierung des Substrats vor sich geht, zu beeinflußen und auch um den Einbau von Sauerstoff in das auf das Substrat aufgebrachte Metall zu verhindern, in Vakuum und/oder in einer inerten Atmosphäre zu metallisieren. Wie bereits weiter oben ausgeführt, ist in diesem Fall die bei der Durchführung des erfindungsgemäßen Verfahrens verwendete Anordnung etwas aufwendiger ausgestattet. Die angewandte Tesla-Spannung liegt bei einer Hochfrequenz im Bereich zwischen 400 und 500 kHz in einem Bereich zwischen 10 und 100 KV, bevorzugt bei ungefähr 50 KV, und die Leistungsdichte im Bereich zwischen 0,1 und 100 W/cm$^2$, bevorzugt bei 5 W/cm$^2$. Die an die leitenden Bereiche 2 gelegte Vorspannung liegt im Bereich zwischen 0 und 100 Volt. Die Kantenschärfe des bei der Metallisierung erzeugten Musters bzw. seine Übereinstimmung mit dem die leitenden Bereiche bildenden Muster ist um so besser, je kleiner der Abstand $d_2$ ist. Das den leitenden Bereichen 2 gegenüberliegende Material der Metallplatte 3 wird bei dem erfindungsgemäßen Verfahren in Sekundenbruchteilen auf den leitenden Bereichen 2 abgeschieden. Sofern es notwendig ist, die Abscheidungsgeschwindigkeit zu beeinflussen, so kann dies durch Variation insbesondere folgender Parameter: der Abstand $d_2$, die Leistungsdichte, die Adhäsion des Films auf der isolierenden Schicht 4, die Vorspannung an den leitenden Bereichen, den Druck und die Gasatmosphäre erfolgen. Schichten, welche übertragen werden, können Dicken bis zur Größenordnung von Mikrometern aufweisen. Bei dem Verfahren werden ausschließlich die leitenden Bereiche 2 metallisiert, d.h. das Verfahren funktioniert selbstjustierend.

Zusammenfassend läßt sich zu dem erfindungsgemäßen Verfahren sagen, das seine besonderen Vorteile darin liegen, daß es selbstjustierend, trocken und ohne den Einsatz von Masken durchgeführt wird, daß es eine selektive Metallisierung und darüber hinaus eine mehrlagige selektive Metallisierung in einem Schritt ermöglicht und daß die auf die leitenden Bereiche aufgebrachten Schichten eine gute Haftung haben. Es wurde außerdem festgestellt, daß die Haftung durch eine nachfolgende thermische Behandlung noch gesteigert werden kann.

Vorteilhaft einsetzbar ist das Verfahren zur Herstellung von Leiterzügen auf oder in - auch mehrlagigen - Moduls und Schaltkarten und Halbleiterkörpern und von Reproduktionen metallischer Strukturen, z. B. für Analysezwecke, zur Kontaktverbesserung von Lötpunkten und als Repariertechnik.

Im folgenden wird am Beispiel des Aufbringens von Gold bzw. von Gold und Kupfer das erfindungsgemäße Verfahren noch genauer erläutert. Bei allen im Zusammenhang damit durchgeführten Experimenten wurde eine Anordnung verwendet, welche in schematischer Querschnittsdarstellung in der Figur gezeigt ist, waren die leitenden Bereiche geerdet, lag die Tesla-Spannung bei ungefähr 50 KV (450 KHz), die Leistungsdichte bei ungefähr 5 W/cm$^2$ und der Abstand $d_2$ bei ungefähr 10 μm. Bei den ersten vier Experimenten bestand das Substrat aus einem Keramikmaterial und die leitenden Bereiche waren mittels einer Molybdänpaste auf die Substratoberfläche aufgedruckt worden. Die Metallplatte 3 bestand beim ersten Experiment aus einer ungefähr 25 nm dicken Goldschicht, beim zweiten aus einer ungefähr 100 nm Goldschicht, beim dritten aus einer ungefähr 1 μm dicken Goldschicht und beim vierten Experiment aus einer an die isolierende Platte 4 grenzende ca. 25 nm dicken Kupferschicht und einer ungefähr 25 nm dicken Goldschicht. Beim fünften Experiment bestand das Substrat aus einem Siliciumplättchen auf das Aluminiumpunkte aufgedampft worden waren. Auch bei diesem fünften Experiment bestand die Metallplatte aus einer Goldschicht. Bei allen vier Experimenten wurde das den leitenden Bereichen gegenüberliegende Metall im Bruchteil von Sekunden auf den leitenden Bereichen abgeschieden. Die einzelnen Experimente wurden jeweils mehrmals durchgeführt und zwar sowohl mit geerdeten als auch mit auf einem schwebenden Potential liegenden leitenden Bereichen, wobei keine Unterschiede bei dem aufgebrachten Schichten festgestellt wurden. Die Übertragung erfolgte jeweils mit einer sehr hohen Mustertreue, d.h. daß das bei der Metallisierung gebildete Muster mit dem aus den leitenden Bereichen gebildeten Muster sehr genau übereinstimmte. Die Haftung der aufgebrachten Metallisierung war in allen Fällen zufriedenstellend.

**Patentansprüche**

1. Verfahren zum selektiven und selbstjustierenden Aufbringen von mindestens einer Metallschicht auf leitende Bereiche (2) an der Oberfläche von isolierenden oder halbleitenden Substraten (1), dadurch gekennzeichnet,

daß eine Metallplatte (3), welche aus mindestens einer Schicht von auf die leitenden Bereiche (2) aufzubringendem Metall besteht, in einem geringen Abstand ($d_2$) gegenüber der die leitenden Bereiche (2) aufweisenden Oberfläche des Substrats (1) angeordnet wird, und daß zwischen der Metallplatte (3) und den leitenden Bereiche Tesla-Ströme erzeugt werden.

2. Verfahren nach Anspruch 1,
dadurch gekennzeichnet,
daß mindestens ein Metall aus der Gruppe Silber, Gold, Nickel, Kupfer aufgebracht wird.

3. Verfahren nach Anspruch 1 oder 2,
dadurch gekennzeichnet,
daß bei einer Frequens im Bereich zwischen 400 und 500 KHz bei einer Tesla-Spannung im Bereich zwischen 10 und 100 KV, einer Leistungsdichte im Bereich zwischen 0,1 und 100 $W/cm^2$ und einem Abstand ($d_2$) zwischen Metallplatte (3) und zu beschichtendem Substrat (1) im Bereich zwischen 5 und 100 $\mu m$ gearbeitet wird.

4. Verfahren nach Anspruch 3.
dadurch gekennzeichnet,
daß bei einer Frequenz von etwa 450 KHz, einer Tesla-Spannung von etwa 50 KV, einer Leistungsdichte von etwa 5 $W/cm^2$ und einem Abstand ($d_2$) zwischen Metallplatte (3) und zu beschichtendem Substrat (1) von ungefähr 10 $\mu m$ gearbeitet wird.

5. Verfahren nach einem der Ansprüche 1 bis 4,
dadurch gekennzeichnet,
daß die leitenden Bereiche (2) auf einem schwebenden oder einem festen Potential zwischen 0 und +100 Volt liegen.

6. Verfahren nach einem der Ansprüche 1 bis 5,
dadurch gekennzeichnet,
daß im selben Arbeitsgang mindestens 2 Schichten aus unterschiedlichen Metallen unter Verwendung einer Metallplatte (3), welche aus mindestens zwei Schichten aus je einem der aufzubringenden Metalle besteht, aufgebracht werden.

7. Verfahren nach einem der Ansprüche 1 bis 6,
dadurch gekennzeichnet,
daß es bei Normaldruck oder im Vakuum in einer aus Luft oder einem Inertgas bestehenden Atmosphäre durchgeführt wird.

8. Verfahren nach Anspruch 7,
dadurch gekennzeichnet,
daß die Steuerung der Abscheidegeschwindigkeit über die Einstellung des Abstands ($d_2$) , des Potentials, auf welchem die leitenden Bereiche (2) liegen, des Drucks und bei Ausbildung der Metallplatte (3) als Auflage auf einer isolierenden Platte (4) über die Variation der Adhäsion der Metallplatte auf der isolierenden Platte erfolgt.

9. Verfahren nach einem der Ansprüche 1 bis 8,
dadurch gekennzeichnet,
daß das aufgebrachte Metall thermisch behandelt wird.

10. Anordnung zur Durchführung des Verfahrens nach einem der Patentansprüche 1 bis 9,
dadurch gekennzeichnet,
daß eine Metallplatte (3), welche aus mindestens einer Schicht von auf die leitenden Bereiche (2) aufzubringendem Metall besteht, in einem geringen Abstand ($d_2$) gegenüber der die leitenden Bereiche (2) aufweisenden Oberfläche des Substrats angeordnet ist, daß ein Metallgitter (5) vorgesehen ist, welches auf der von den leitenden Bereichen (2) abgewandten Seite der Metallplatte (3) angeordnet ist und regelmäßig verteilt auf die Metallplatte (3) gerichtete Spitzen (6) aufweist, oder daß ein Büschel von Drähten vorgesehen ist, dessen Spitzen in gleichmäßiger Verteilung auf die von den leitenden Bereichen (2) abgewandte Seite der Metallplatte gerichtet sind, wobei die genannten Spitzen des Metallgitters bzw. des Büschels von Drähten elektrisch mit der Metallplatte verbunden sein können, und daß ein Tesla-Transformator (7) vorhanden ist, welcher elektrisch mit dem Metallgitter (5) oder Büschel von Drähten verbunden ist.

11. Anordnung nach Anspruch 10,
dadurch gekennzeichnet,
daß sie eine evakuierbare Reaktionskammer, in welcher das Aufbringen des Metalls stattfindet, und an der Reaktionskammer einen Gaseinlaß zum Zugeben.

12. Anordnung nach Anspruch 10 oder 11,
dadurch gekennzeichnet,
daß sie eine mit der von den leitenden Bereichen (2) abgewandten Seite der Metallplatte (3) verbundene, isolierende und im Abstand ($d_1$) von den Spitzen des Metallgitters (5) angeordnete Platte (4) aufweist.

13. Anordnung nach einem der Ansprüche 10 bis 12,
dadurch gekennzeichnet,
daß sie Mittel (8) aufweist, um ein festgelegtes Potential an die leitenden Bereiche (2) zu legen.

14. Verwendung des Verfahrens nach einem der Ansprüche 1 bis 9, zur Verstärkung von leitenden Mustern durch eine Metallauflage, insbesondere zur Herstellung von Leiterzügen auf oder in Modulen aus Keramik- oder Glaskeramikmaterial, Schaltkarten und Halbleiterkörpern, von Reproduktionen metallischer Strukturen, zum Füllen von Löchern in isolierenden Schichten zwischen zwei Metallisierungsebenen, die dadurch elektrisch miteinander verbunden werden, zur Kontaktverbesserung von Lötpunkten, und als Repariertechnik.

**Claims**

1. Method for the selective and self-aligned deposition of at least one metal layer on conductive regions (2) on the surface of isolating or semiconductive substrates (1), characterized in that a metal plate (3), which consists of at least one layer of metal to be deposited on the conductive regions (2), is arranged at a short spacing ($d_2$) opposite the surface of substrate (1) comprising the conductive regions (2), and that Tesla currents are generated between the metal plate (3) and the conductive regions (2).

2. Method according to claim 1, characterized in that at least one metal of the group silver, gold, nickel, copper is deposited.

3. Method according to claim 1 or 2, characterized in that a frequency ranging from 400 to 500 KHz, a Tesla voltage ranging from 10 to 100 KV, a power density ranging from 0.1 to 100 W/cm$^2$, and a spacing ($d_2$) ranging from 5 to 100 um between the metal plate (3) and the substrate (1) to be coated are used.

4. Method according to claim 3, characterized in that a frequency of about 450 KHz, a Tesla voltage of about 50 KV, a power density of about 5 W/cm$^2$, and a spacing ($d_2$) of about 10 $\mu$m between the metal plate (3) and substrate (1) to be coated are used.

5. Method according to any one of the claims 1 to 4, characterized in that the conductive regions (2) are connected to a floating or a fixed potential ranging from 0 to +100 V.

6. Method according to any one of the claims 1 to 5, characterized in that at least two layers of different metals are applied in the same step, using a metal plate (3) made up of at least two layers each consisting of one of the metals to be deposited.

7. Method according to any one of the claims 1 to 6, characterized in that it is implemented at normal pressure or in a vacuum in an atmosphere consisting of air or an inert gas.

8. Method according to claim 7, characterized in that the deposition rate is controlled as a function of the spacing ($d_2$), the potential to which the conductive regions (2) are connected, the pressure, and, if the metal plate (3) is formed as a layer on an insulating plate (4), as a function of the variation of the adhesion of the metal plate on the insulating plate.

9. Method according to any one of the claims 1 to 8, characterized in that the deposited metal is thermally treated.

10. Arrangement for implementing the method according to any one of the patent claims 1 to 9, characterized in that a metal plate (3), consisting of at least one layer of metal to be deposited on the conductive regions (2), is arranged at a short spacing ($d_2$) opposite to the surface of the substrate comprising the conductive regions (2), that a metal grid is provided which is positioned on the side of the metal plate (3) averted from the conductive regions (2) and which has regularly distributed spikes (6) pointing at the metal plate (3), or that a bundle of wires is provided, whose regularly distributed tips point at the side of the metal plate averted from the conductive regions (2), wherein the spikes of the metal grid and the tips of the wire bundle may be electrically connected to the metal plate, and that a Tesla transformer (7) is provided which is electrically connected to the metal grid (5) or to the wire bundle.

11. Arrangement according to claim 10, characterized in that it comprises an evacuatable reaction chamber in which the metal is deposited and at which a gas inlet is provided for adding defined quantities of gas.

12. Arrangement according to claim 10 or 11, characterized in that it comprises an insulating plate (4) connected to the side of the metal plate (3) averted from the conductive regions (2) and which is arranged at a spacing ($d_1$) from the spikes of the metal grid (5).

13. Arrangement according to any one of the claims 10 to 12, characterized in that it comprises means (8) for applying a predetermined potential to the conductive regions (2).

14. Use of the method according to any one of the claims 1 to 9 to reinforce conductive patterns by depositing a metal layer, in particular to produce conductors on or in modules of ceramic or glass ceramic material, circuit boards and semiconductor elements, to reproduce metallic structures, to fill holes in isolating layers between two metallization planes which are thus electrically connected to each other, to improve the contact of solder points, and as a repair means.

**Revendications**

1. Procédé pour réaliser le dépit sélectif, avec autoalignement, d'au moins une couche métallique sur les régions conductrices (2) à la surface de substrats (1) isolants ou semiconducteurs, caractérisé en ce qu'on dispose une plaque métallique (3), qui est constituée par au moins une couche d'un métal devant être déposé sur les régions conductrices (2), à une faible distance ($d_2$) en vis-à-vis de la surface du substrat (1), comportant les régions conductrices (2), et produit des courants Tesla entre la plaque métallique (3) et les régions conductrices (2).

2. Procédé selon la revendication 1, caractérisé en ce qu'on dépose au moins un métal du groupe incluant l'argent, l'or, le nickel et le cuivre.

3. Procédé selon la revendication 1 ou 2, caractérisé en ce que, dans le cas d'une fréquence située dans la gamme comprise entre 400 et 500 kHz et pour une tension Tesla située dans la gamme comprise entre 10 et 100 kV, on travaille avec une densité d'énergie située dans la gamme comprise entre 0,1 et 100 W/cm$^2$ et avec une distance ($d_2$) entre la plaque métallique (3) et le substrat (1) devant être recouvert, dans la gamme comprise entre 5 et 100 $\mu$m.

4. Procédé selon la revendication 3, caractérisé en ce que pour une fréquence d'environ 450 kHz et pour une tension Tesla d'environ 50 kV, on travaille avec une densité d'énergie d'environ 5 W/cm2 et avec une distance ($d_2$) entre la plaque métallique (3) et le substrat (1) devant être recouvert, égale à environ 10 μm.

5. Procédé selon l'une des revendications 1 à 4, caractérisé en ce que les régions conductrices (2) sont placées à un potentiel flottant ou à un potentiel fixe compris entre 0 et +100 volts.

6. Procédé selon l'une des revendications 1 à 5, caractérisé en ce que, lors de la même étape opératoire, on dépose au moins 2 couches constituées par des métaux différents en utilisant une plaque métallique (3) constituée par au moins deux couches formées chacune par l'un des métaux devant être déposés.

7. Procédé selon l'une des revendications 1 à 6, caractérisé en ce qu'on le met en oeuvre à une pression normale ou dans le vide, dans une atmosphère constituée d'air ou d'un gaz inerte.

8. Procédé selon la revendication 7, caractérisé en ce que la commande de la vitesse de dépôt s'effectue en fonction du réglage de la distance ($d_2$) du potentiel auquel les régions conductrices (2) sont placées, de la pression et, dans le cas de la réalisation de la plaque métallique (3) sous la forme d'un revêtement sur une plaque isolante (4), par l'intermédiaire de la variation de l'adhérence de la plaque métallique à la plaque isolante.

9. Procédé selon l'une des revendications 1 à 8, caractérisé en ce qu'on fait subir un traitement thermique au métal déposé.

10. Dispositif pour la mise en oeuvre du procédé selon l'une des revendications 1 à 9, caractérisé en ce qu'une plaque métallique (3), qui est constituée par au moins une couche d'un métal devant être déposé sur les régions conductrices (3), est disposée à une faible distance ($d_2$) en vis-à-vis de la surface du substrat, qui comporte les régions conductrices (2), qu'il est prévu une grille métallique (5) qui est disposée sur le côté de la plaque métallique (3) tourné à l'opposé des régions conductrices (2) et comporte des pointes (6) dirigées, conformément à une répartition régulière, en direction de la plaque métallique (3), ou qu'il est prévu un faisceau de fils, dont les pointes sont dirigées, conformément à une répartition uniforme, en direction de la face de la plaque métallique, tournée à l'opposé des régions conductrices (2), auquel cas lesdites pointes de la grille métallique ou du faisceau de fils peuvent être reliées électriquement à la plaque métallique, et qu'il est prévu un transformateur Tesla (7), qui est relié électriquement à la grille métallique (5) ou au faisceau de fils.

11. Dispositif selon la revendication 10, caractérisé en ce qu'il comporte une enceinte de réaction, dans laquelle le vide peut être créé et dans laquelle le dépôt du métal s'effectue, et une admission de gaz raccordée à l'enceinte de réaction et servant à introduire des quantités définies de gaz.

12. Dispositif selon la revendication 10 ou 11, caractérisé en ce qu'il comporte une plaque isolante (4) reliée à la face de la plaque métallique (3), tournée à l'opposé des régions conductrices (2), et située à une distance ($d_1$) des pointes de la grille métallique (5).

13. Dispositif selon l'une des revendications 10 à 12, caractérisé en ce qu'il comporte des moyens (8) permettant d'appliquer un potentiel fixe aux régions conductrices (2).

14. Application du procédé selon l'une des revendications 1 à 9 pour renforcer des configurations conductrices au moyen d'un dépôt de métal, notamment pour fabriquer des voies conductrices ou bien, dans des modules réalisés en un matériau céramique ou en vitrocérame, des cartes à circuits imprimés et des corps semiconducteurs, pour la fabrication de reproductions de structures métalliques, pour le remplissage de trous dans des couches isolantes situées entre deux plans de métallisation, qui doivent être reliés électriquement entre eux, afin d'améliorer le contact de points de soudure, et en tant que technique de réparation.